# EUROPÄISCHE PATENTSCHRIFT

(11) **EP 1 490 908 B1**
(45) Veröffentlichungstag und Bekanntmachung des Hinweises auf die Patenterteilung: **06.06.2007**
(21) Anmeldenummer: 03724855.6
(22) Anmeldetag: 01.04.2003
(51) Int. Cl.: H01L 25/16, H01L 23/433, H01L 23/31

(54) **LEISTUNGSMODUL MIT ZWEI SUBSTRATEN UND VERFAHREN ZU SEINER HERSTELLUNG**
POWER MODULE COMPRISING AT LEAST TWO SUBSTRATES AND METHOD FOR PRODUCING THE SAME
MODULE DE PUISSANCE COMPORTANT AU MOINS DEUX SUBSTRATS ET PROCEDE PERMETTANT DE LE PRODUIRE

(30) Priorität: 04.04.2002 DE 10214953
(43) Veröffentlichungstag der Anmeldung: 29.12.2004
(73) Patentinhaber: Infineon Technologies AG, 81669 München (DE)
(72) Erfinder: HABLE, Wolfram, 92318 Neumarkt (DE)
(74) Vertreter: Schäfer, Horst
(86) Internationale Anmeldenummer: PCT/DE2003/001067
(87) Internationale Veröffentlichungsnummer: WO 2003/085738

(56) Entgegenhaltungen:
- EP-A- 0 578 108
- DE-A- 10 048 379
- DE-A- 19 741 047
- DE-A- 19 924 991
- US-A- 5 332 921
- US-A1- 2002 012 239

## Beschreibung

Die Erfindung betrifft ein Leistungsmodul mit mindestens zwei Substraten und ein Verfahren zu seiner Herstellung.

Um intelligente Leistungsmodule zu schaffen, werden zunehmend Logikschaltungen und passive Bauelemente neben den Leistungsbauelementen in Hybridbauweise in einem Leistungsmodul integriert. Mit zunehmender Zahl von Signalhalbleiterchips auf der Substratfläche wird der Bedarf an teurer Substratkeramik ständig größer, so dass die Kosten für intelligente Leistungsmodule ständig steigen. Diese Kosten können auch nicht dadurch vermindert werden, dass mehrere Substrate übereinander gestapelt werden, zumal die Stütz- und Verbindungstechnik bei gestapelten Strukturen ebenfalls die Kosten in die Höhe treibt.

Aufgabe der Erfindung ist es, ein Leistungsmodul anzugeben, das sowohl Leistungshalbleiterchips als auch Signalhalbleiterchips aufweist, das einfach und preiswert herzustellen ist und den Flächenbedarf für ein Substrat mit Halbleiterchips trotz zusätzlicher Signalhalbleiterchips nicht vergrößert.

Diese Aufgabe wird mit dem Gegenstand der unabhängigen Ansprüche gelöst. Vorteilhafte Weiterbildungen der Erfindung ergeben sich aus den abhängigen Ansprüchen.

Erfindungsgemäß wird ein Leistungsmodul mit einem ersten Substrat, das mit Leitungshalbleiterchips bestückt ist und einem zweiten Substrat, das mit Signalhalbleiterchips bestückt ist, geschaffen. Dabei sind die Substrate in dem Leistungsmodul parallel übereinander ausgerichtet und ihre Bestückungsseiten zueinander angeordnet. Die beiden Bestückungsseiten sind elektrisch miteinander über gebogene Bonddrähte verbunden, die die Funktion eines Scharniers haben, wobei die Bonddrähte gleichzeitig den Abstand zwischen dem ersten und dem zweiten Substrat definieren und mechanisch das zweite Substrat über dem ersten Substrat fixieren und die beiden Substrate in eine Kunststoffgehäusemasse einbettbar sind.

Ein derartiges Leistungsmodul hat den Vorteil, dass für die Leistungshalbleiterchips ein entsprechend wärmefestes und wärmeleitendes Substrat vorgesehen werden kann, während für die Signalhalbleiterchips ein weitaus preiswerteres Substrat, das keine große Wärmebelastung erfährt, eingesetzt werden kann. Durch die scharnierartig gebogenen Bonddrähte entfällt weiterhin eine komplexe Stützmechanik, um den Abstand zwischen den beiden Substraten zu definieren, vielmehr kann das zweite Substrat mit Hilfe der scharnierartig gebogenen Bonddrähte in einem definierten Abstand von dem ersten Substrat gehalten werden, wobei sich die beiden Bestückungsseiten gegenüberstehen. Die scharnierartig gebogenen Bonddrähte bilden außerdem eine mechanische Fixierung der Position des zweiten Substrats über dem ersten Substrat und beide Substrate einschließlich ihrer Halbleiterchips können in diesem über scharnierartig gebogene Bonddrähte definierten Zustand in eine Kunststoffmasse eingebettet sein.

Ein Leistungsmodul mit einer Treiberschaltkreiskarte und einer Steuerschaltkreiskarte zur Aufnahme von Bauelementen hoher bzw. niedriger Verlustwärmeentwicklung ist in der DE 100 48 379 A1 beschrieben. Die beiden Schaltkreiskarten sind über ein flexibles Substrat mit Leiterbahnen verbunden. Eine solche Anordnung ist jedoch mechanisch nicht stabil und wird in ein Gehäuse eingebaut. Demgegenüber entsteht durch die Verbindung der Substrate über Bonddrähte eine mechanisch stabile Einheit, die in Kunststoffmasse eingebettet werden, aber auch ohne die Einbettung verwendet werden kann. Die Anordnung von Substraten verschiedener Verlustwärmeentwicklung, die mit ihren Bestückungsseiten einander gegenüber liegen, trägt außerdem zu einer Verkleinerung des Moduls und zur Vereinfachung des Vergießens bei.

Das mit Leistungshalbleiterchips bestückte Substrat kann eine Keramikplatte sein, die einerseits eine gute Wärmeableitung ermöglicht und andererseits eine hohe Temperatur- bzw. Wärmefestigkeit aufweist. Damit wird gewährleistet, dass die Leistungshalbleiterchips ihre volle Verlustwärme über die Keramikplatte abführen können. Zur Verbesserung der Wärmeabfuhr kann die Keramikplatte auf einer Wärmesenke aus einer Kupferplatte montiert sein. Um möglichst viele Funktionen mit einer derartigen Keramikplatte zu realisieren kann das mit Leistungshalbleiterchips bestückte Substrat eine mehrlagige Keramikplatte aufweisen. In einer derartigen mehrlagigen Keramikplatte wechseln sich isolierende Lagen mit metallischen Strukturen ab, wobei die metallischen Strukturen der einzelnen Metall-Lagen über Durchkontakte durch die Isolationslagen untereinander verbunden sind.

Für die geringe Verlustleistung erzeugenden Signalhalbleiterchips ist ein zweites Substrat vorgesehen, das eine Leiterplatte aus glasfaserverstärktem Kunststoff aufweist. Dieser glasfaserverstärkte Kunststoff kann auf das Aufdehnüngsverhalten des Halbleiterchips abgestimmt sein. Insbesondere durch die Ausrichtung der Glasfasern in x- und y-Richtung kann das mit Signalhalbleiterchips bestückte Substrat einen thermischen Ausdehnungskoeffizienten aufweisen, der annähernd dem thermischen Ausdehnungskoeffizienten eines Halbleiterchips wie Silicium entspricht. In z-Richtung kann jedoch der thermische Ausdehnungskoeffizient des zweiten Substrats für die Signalhalbleiterchips einen für Kunststoff üblichen Wert aufweisen, da in z-Richtung dem Substrat für die Signalhalbleiterchips keine thermischen Ausdehnungsbeschränkungen auferlegt werden müssen.

Bei dichter Bestückung des zweiten Substrats mit Signalhalbleiterchips kann es vorteilhaft sein, dass als zweites Substrat eine mehrlagige Leiterplatte aus glasfaserverstärktem Kunststoff eingesetzt wird. Ein derartiges zweites Substrat aus einer glasfaserverstärkten Leiterplatte kann durch Logikhalbleiterbauteile, Signalhalbleiterchips, integrierte Steuerschaltungen, integrierte Treiberschaltungen oder auch Temperatursensoren die Einsatzmöglichkeiten des Leistungsmoduls erweitern.

Das mit Signalhalbleiterchips bestückte zweite Substrat kann darüber hinaus passive Komponenten, wie Widerstände, Kondensatoren oder Induktivitäten aufweisen, die sowohl in Dünnfilmtechnik als auch in Dickfilmtechnik auf der Leiterplatte des zweiten Substrats realisierbar sind.

Im Gegensatz zu dem zweiten Substrat aus einer Leiterplatte mit Signalhalbleiterchips, die nur geringe Verlustwärme entwickeln, sind auf dem ersten Substrat Leistungshalbleiterchips, wie bipolare Leistungstransistoren mit isoliertem Gate, angeordnet, die eine hohe Verlustleistung aufweisen und diese Verlustleistung über eine entsprechend gut wärmeleitende Keramikplatte als Substrat an die Umgebung abgeben. Anstelle von bipolaren Leistungstransistoren kann das erste Substrat auch Leistungshalbleiterchips als Metalloxid-Leistungsfeldeffekttransistoren aufweisen. Diese, abgekürzt MOS-Leistungstransistoren entwickeln ebenfalls eine hohe Verlustwärme, so dass eine Keramikplatte als erstes Substrat für diese Leistungshalbleiterchips geeignet erscheint. Ein weiterer Vorteil von Keramikplatten für derartige Leistungshalbleiterchips ist, dass Keramikplatten mit ihrem thermischen Ausdehnungskoeffizienten relativ genau an den thermischen Ausdehnungskoeffizienten des Halbleitermaterials angepaßt werden kann. Somit entstehen trotz erheblicher Verlustwärmeentwicklung keine erheblichen thermischen Spannungen zwischen den Leistungshalbleiterchips und dem ersten Substrat.

Zur Schaffung intelligenter Leistungsmodule sollen die Signalhalbleiterchips auf der zweiten Halbleiterplatte mit den Leistungshalbleiterchips auf dem ersten Substrat elektrisch zusammenwirken. Dieses wird über Leiterbahnen auf dem zweiten Substrat mit Signalhalbleiterchips und den scharnierartig gebogenen Bonddrähten, die mit entsprechenden Leiterbahnen auf dem ersten Substrat in Verbindung stehen, erreicht.

Die scharnierartig gebogenen Bonddrähte können Aluminium und/oder eine Aluminiumlegierung aufweisen und haben eine Mindestdicke von 100 Mikrometer, um die mechanische Festigkeit beziehungsweise den definierten Abstand zwischen dem ersten Substrat und dem zweiten Substrat zu halten. Aufgrund der Verarbeitbarkeit von Aluminiumbonddrähten liegt die obere Grenze für den Durchmesser der Aluminiumbonddrähte bei etwa 300 Mikrometer.

Ein erfindungsgemäßes Verfahren zur Herstellung eines Leistungsmoduls mit einem ersten Substrat, das mit Leistungshalbleiterchips bestückt ist und einem zweiten Substrat, das mit Signalhalbleiterchips bestückt ist, weist folgende Verfahrensschritte auf:

Zunächst wird ein erstes Substrat, das mit Leistungshalbleiterchips bestückt ist und ein zweites Substrat, das mit Signalhalbleiterchips bestüc-kt ist, bereitgestellt. Diese beiden Substrate werden so zueinander ausgerichtet, dass ihre Bestückungsseiten benachbart nebeneinander angeordnet sind und in jeweils einer Zeile angeordnete Bondflächen aufweisende Randbereiche der Bestückungsseiten beider Substrate nebeneinander liegen. Nach dem Ausrichten werden die Substrate an dem Bondflächen aufweisenden Randbereich mit Bonddrähten verbunden, die parallel zueinander angeordnet werden.

Nach dem Herstellen aller Bondverbindungen in den Randbereichen des ersten und zweiten Substrats wird das zweite Substrat um 180° unter Verbiegen der parallel zueinander angeordneten Bonddrähte umgeklappt wobei die Bonddrähte die Funktion eines Scharniers ausüben, so dass die Substrate parallel übereinander ausgerichtet und ihre Bestückungsseiten zueinander angeordnet sind. Abschließend werden die derart angeordneten Substrate zu Leistungsmodulen in einem Kunststoffgehäuse verpackt.

Dieses Verfahren hat den Vorteil, dass mit dem Herstellen der Bondverbindungen zwischen zwei in Zeilen angeordneten Bondflächenzeilen in den Randbereichen der beiden Substrate eine einfache Lösung gefunden ist, die einerseits preiswert zu realisieren ist, andererseits keine teure Substratfläche für Leistungshalbleiter verbraucht und schließlich voll automatisierbar ist. Auch das Umklappen des zweiten Substrats über das erste über Verbiegen der scharnierartig angeordneten Bondverbindungen zwischen den beiden Substraten kann mit Unterstützung eines Vakuumwerkzeuges automatisiert durchgeführt werden. Abschließend können die Substrate mit den Leistungshalbleiterchips und den Signalhalbleiterchips in einem Kunststoffgehäuse verpackt werden.

Zum Bereitstellen eines ersten Substrats mit Leistungshalbleiterchips wird zunächst eine Keramikplatte mit einer Leiterbahnstruktur beschichtet. In einem Randbereich dieser Leiterbahnstruktur wird eine Zeile nebeneinander unter vorgegebenem Rastermaß angeordneter Bondflächen vorgesehen. Danach werden auf dem ersten Substrat die Leistungshalbleiterchips angeordnet und untereinander sowie mit der Leiterbahnstruktur über Bonddrähte unter Freilassung der Bondflächenzeile verbunden. Schließlich können auf der Keramikplatte innere Flachleiterenden an dafür vorgesehenen Leiterbahnen der Leiterbahnstruktur angeordnet werden, wobei diese Flachleiterenden zu Außenflachleitern gehören, die einerseits mit Versor-gungsspannungen verbunden werden können und andererseits für das Anlegen und Abgreifen von Signalen vorgesehen sind.

Zum Bereitstellen eines zweiten Substrats mit Signalhalbleiterchips wird eine Leiterplatte mit einer Leiterbahnstruktur versehen, die in einem Randbereich eine Zeile nebeneinander angeordneter Bondflächen aufweist, deren Anzahl und Rastermaß der Bondflächenzeile des ersten Substrats entspricht. Auf der Leiterbahnstruktur können dann die Signalhalbleiterchips angeordnet werden und über Bonddrähte unter Freilassung der Bondflächenzeile verbunden werden. Da das Substrat für die Signalhalbleiterchips eine Leiterplatte ist, können relativ preiswert beliebig viele Signalhalbleiterchips auf der Leiterplatte untergebracht werden. Diese Signalhalbleiterchips können Logikschaltungen, Sensorschaltungen, passive Bauelemente, Treiberschaltungen und andere Steuerschaltungen aufweisen.

Als Sensorschaltungen werden bevorzugt Temperatursensoren eingesetzt, um beispielsweise das Leistungsmodul thermisch zu überwachen. Vor einem Verbinden der beiden Substrate über entsprechende parallel zueinander angeordnete Bonddrähte werden die beiden Substrate derart zueinander ausgerichtet, dass die Bondflächenzeilen der Substrate nebeneinander angeordnet sind. Somit ist mit einer einfachen und preiswerten Bondverbindungstechnik ein elektrisches und mechanisches Verbinden der beiden zueinander ausgerichteten Substrate auf den aufeinander angepaßten Bondflächen möglich.

Das Verbinden kann mittels Thermokompressions-Sonicbonden von Aluminium und/oder Aluminiumlegierungsbonddrähten erfolgen, wobei diese Bonddrähte einen Durchmesser aufweisen, der mindestens 100 Mikrometer beträgt, um die mechanische Stabilität zu gewährleisten. Aufgrund der üblichen Bondwerkzeuge ist dieser Durchmesser nach oben hin begrenzt und sollte 300 Mikrometer nicht übersteigen.

Mittels eines Vakuumwerkzeugs kann dann vollautomatisch das Umklappen des zweiten Substrats um 180° unter Verbiegen der parallel zueinander angeordneten Bonddrähte erfolgen, so dass die Substrate parallel übereinander ausgerichtet sind und ihre Bestückungsseiten zueinander angeordnet sind. Auf diese Weise wird gleichzeitig eine sehr kompakte Anordnung aus zwei mit Halbleiterchips bestückten Substraten für ein Leistungsmodul geschaffen. Diese kompakte Anordnung der beiden Substrate kann anschließend in einem Kunststoffgehäuse mittels Spritzgußtechnik unter Einbetten der übereinander angeordneten Substrate in eine Kunststoffgehäusemasse erfolgen.

Eine weitere Möglichkeit das Leistungsmodul zu verpacken besteht darin, die beiden aufeinandergeklappten Substrate in einem vorgefertigten Kunststoffgehäuse anzuordnen und anschließend die Hohlräume zwischen den Substraten und dem vorgefertigten Kunststoffgehäuse mit Siliconmasse aufzufüllen. Vor dem Anordnen eines Kunststoffgehäuses über den beiden Substraten kann das erste Substrat, auf dem die Leistungshalbleiterchips angeordnet sind auf einer Metallplatte, die vorzugsweise Kupfer oder eine Kupferlegierung aufweist, montiert werden. Diese Metallplatte bildet einerseits eine Au-ßenwand für das Kunststoffgehäuse und andererseits eine wirkungsvolle Wärmesenke für die Verlustwärme.

Nach dem Verpacken des Leistungsmoduls in einem Kunststoffgehäuse ragen Außenflachleiter aus dem Kunststoffgehäuse heraus, die einerseits mit den Leistungshalbleiterchips und andererseits über die scharnierförmig gebogenen Bonddrähte mit den Signalhalbleiterchips elektrisch verbunden sind. Die Querschnitte dieser Außenflachleiter können der Leistungsaufnahme für die Leistungshalbleiterchips angepaßt sein und einen größeren Querschnitt aufweisen als Außenflachleiter, die für die Leistungshalbleiterchips bereitgestellt werden.

Die Erfindung wird nun anhand von Ausführungsformen mit Bezug auf die beiliegenden Figuren näher erläutert.
- Figur 1: zeigt eine schematische, teilweise aufgebrochene, perspektivische Ansicht einer ersten Ausführungsform der Erfindung,
- Figuren 2 bis 6: zeigen Prinzipskizzen von Ergebnissen und Zwischenprodukten eines Verfahrens zur Herstellung eines Leistungsmoduls gemäß weiterer Ausführungsformen der Erfindung,

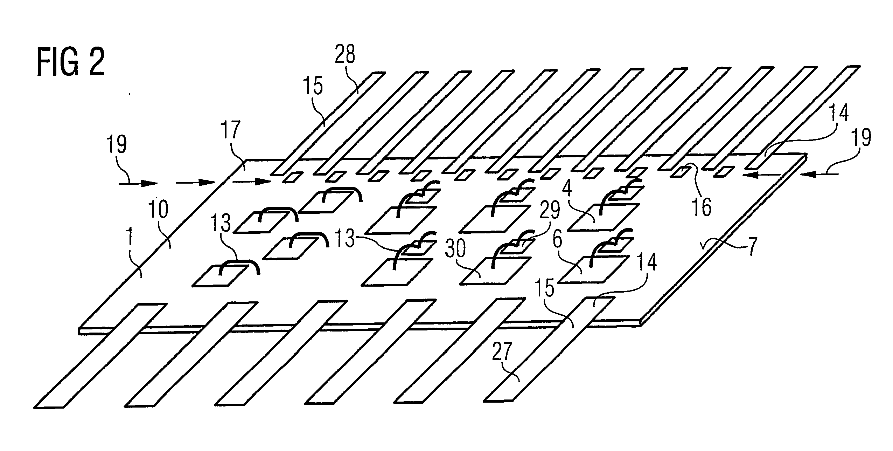

- Figur 2: zeigt ein Keramiksubstrat mit Leistungshalbleiterchips und einer Reihe von Außenflachleitern für eine Leistungsübertragung und eine weitere Reihe von Außenflachleitern für eine Signalübertragung,

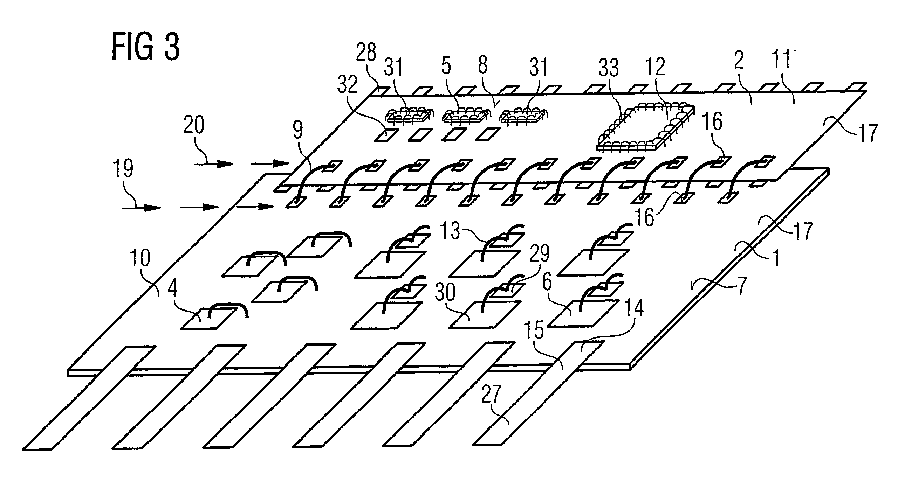

- Figur 3: zeigt eine Prinzipskizze mit einem ersten Substrat, auf dem Leistungshalbleiterchips angeordnet sind und einem zweiten Substrat, das Signalhalbleiterchips aufweist, wobei die Substrate über scharnierartige Bonddrähte miteinander verbunden sind.

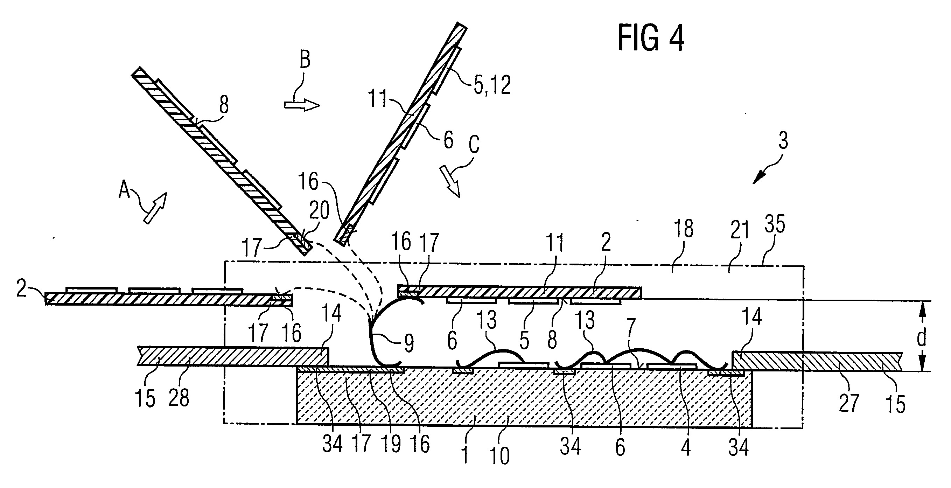

- Figur 4: zeigt einen schematischen Querschnitt durch ein Leistungsmodul vor und nach dem Umklappen des zweiten Substrats,

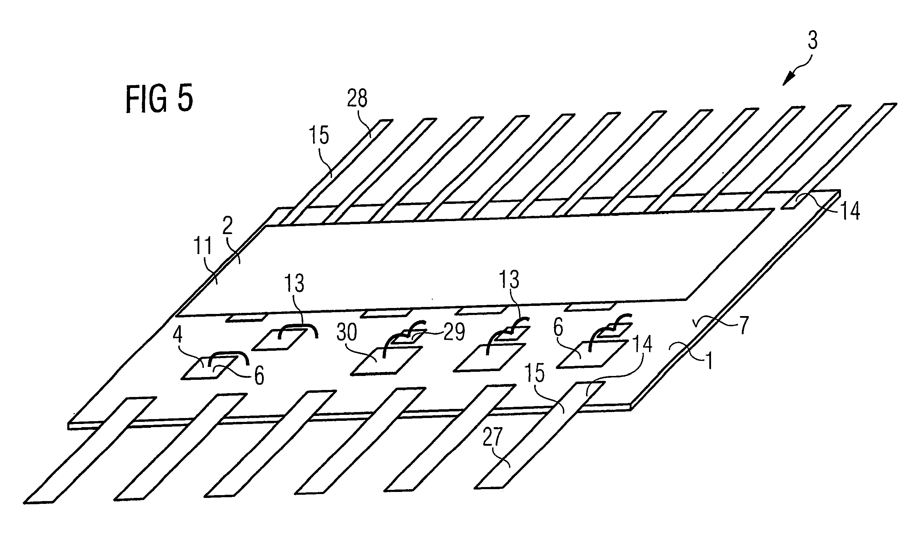

- Figur 5: zeigt eine perspektivische Prinzipskizze eines Leistungsmoduls mit umgeklapptem zweiten Substrat,

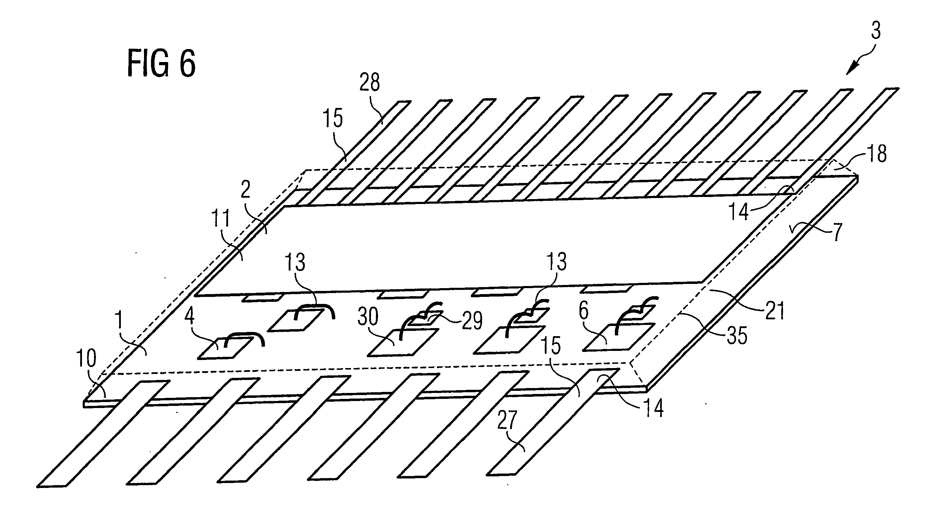

- Figur 6: zeigt eine perspektivische Prinzipskizze eines Leistungsmoduls einer weiteren Ausführungsform der Erfindung,

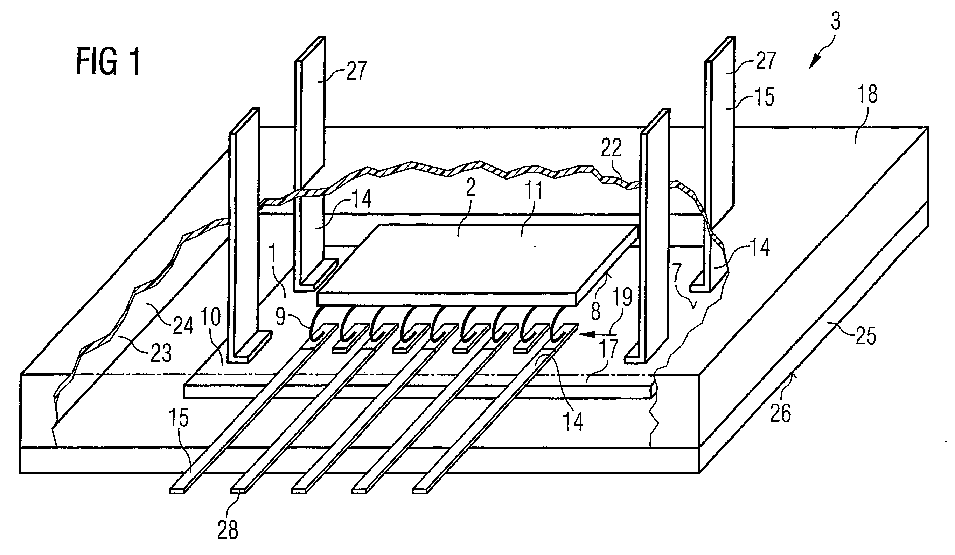

Figur 1 zeigt eine schematische, teilweise aufgebrochene, perspektivische Ansicht eines Leistungsmoduls 3 einer ersten Ausführungsform der Erfindung. Das Bezugszeichen 1 kennzeichnet eine Keramikplatte, die als Substrat 1 nicht gezeigte Leistungshalbleiterchips aufweist. Das Bezugszeichen 2 kennzeichnet ein zweites Substrat, das eine Leiterplatte 11 aus glasfaserverstärktem Kunststoff aufweist und über scharnierartig gebogene Bonddrähte 9 über das erste Substrat 1 geklappt ist. Das Bezugszeichen 7 kennzeichnet die Bestückungsseite des ersten Substrats und das Bezugszeichen 8 kennzeichnet die Bestückungsseite des zweiten Substrats.

Die beiden Bestückungsseiten 7 und 8 sind einander zugewandt, da die beiden Substrate übereinandergeklappt in dem Kunststoffgehäuse 18 angeordnet sind. In dieser Ausführungsform der Erfindung sind vier Außenflachleiter 27 für die Leistungsversorgung der Leistungshalbleiterchips auf dem ersten Substrat 1 mit ihren inneren Flachleiterenden angeordnet und ragen vertikal aus dem Kunststoffgehäuse 18 heraus. Horizontal ragen fünf Außenflachleiter 28 für Signalübertragungen aus dem Kunststoffgehäuse heraus und sind mit ihren inneren Flachleiterenden auf dem Keramiksubstrat befestigt und über die Bonddrähte 9 elektrisch mit den Signalhalbleitern auf dem zweiten Substrat 2 verbunden.

Die scharnierartig gebogenen Bonddrähte 9 sind in einem vorgegebenen Rastermaß auf einer Bondflächenzeile 19 in dem Randbereich 17 der Keramikplatte 10 des ersten Substrats 1 angeordnet. Die Keramikplatte 10 ist auf einer Metallplatte 25 montiert, die in dieser Ausführungsform der Erfindung als Wärmesenke dient und eine Außenwand 26 des Kunststoffgehäuses 18 bildet. Das Kunststoffgehäuse 18 besteht aus einem vorgefertigten Kunststoffgehäuseteil 22, der auf die Metallplatte 25 aufgesetzt ist, und der Hohlraum 23 zwischen dem vorgeformten Kunststoffgehäuse 22 und den Substraten 1 und 2 wird nach dem Aufsetzen auf die Metallplatte mit einer Siliconmasse vergossen.

Mit diesem Aufbau läßt sich preiswert und kompakt ein Leistungsmodul realisieren, das seine Sensoren, Logikschaltungen, Steuerschaltungen und/oder Treiberschaltungen auf dem zweiten Substrat 2 angeordnet hat und auf dem intensiv gekühlten ersten Substrat 1 die Leistungshalbleiterchips in Form MOS-Leistungstransistoren oder bipolaren Leistungstransistoren mit isoliertem Gate oder Leistungsdioden aufweist.

Die Figuren 2 bis 6 zeigen Prinzipskizzen von Ergebnissen und Zwischenprodukten eines Verfahrens zur Herstellung eines Leistungsmoduls gemäß einer weiteren Ausführungsform der Erfindung. Komponenten der Figuren 2 bis 6 mit gleichen Funktionen wie in Figur 1 werden mit gleichen Bezugszeichen gekennzeichnet und nicht extra erörtert.

Figur 2 zeigt ein Keramiksubstrat 1 mit Leistungshalbleiterchips 4 und einer Reihe von Außenflachleitern 27 für eine Leistungsübertragung und eine weitere Reihe mit Außenkontakten 28 für Signalübertragungen. Dabei weisen die Außenflachleiter 28 für Signalübertragungen einen kleineren Querschnitt auf als die Außenflachleiter 27 für Leistungsübertragung. Auf der Keramikplatte 10 sind Leistungsdioden 29 und Leistungstransistoren 30 angeordnet, die über Bondverbindungen 13 untereinander und mit einer nicht gezeigten Leiterbahnstruktur verbunden sind.

Eine Zeile 19, die im Randbereich 17 des Keramiksubstrats 10 angeordnet ist, weist Bondflächen 16 auf, die von Bondverbindungen 13 freigehalten sind. Diese Bondflächen 16 stehen jedoch mit der nicht gezeigten Leiterbahnstruktur elektrisch in Verbindung. Außerdem stehen diese Bondflächen teilweise mit den Außenflachleitern 28 für Signalübertragungen über die Leiterbahnstruktur auf dem Keramiksubstrat 10 elektrisch in Verbindung.

Figur 3 zeigt eine Prinzipskizze mit einem ersten Substrat 1, auf dem Leistungshalbleiterchips 4 angeordnet sind und mit einem zweiten Substrat 2, das Signalhalbleiterchips aufweist, wobei die Substrate 1 und 2 über Bonddrähte 9 miteinander mechanisch und elektrisch verbunden sind. Das zweite Substrat 2 aus einer glasfaserverstärkten Leiterplatte 11 kann Logikchips 12, Steuer- oder Treiberchips 31 und/oder Temperatursensorchips 32 aufweisen, um ein intelligentes Leistungsmodul zu schaffen. Dieses zweite Substrat 2 weist eine nicht im Detail gezeigte Leiterbahnstruktur auf, die mit den Signalhalbleiterchips 5 über Bonddrähte 33 elektrisch verbunden ist. Dabei wird eine Zeile 20 von Bondflächen 16 von internen Bonddrähten 13 des Substrats 2 freigehalten.

Die Bondflächenzeile 20 im Randbereich 17 des Substrats 2 ist derart ausgerichtet, dass sie parallel zu der Bondflächenzeile 19 des Substrats 1 angeordnet ist. Mit einem preiswerten Bondverfahren können somit Bonddrähte 9 aus Aluminium mit einem Mindestdurchmesser von 100 Mikrometer die Bondflächen 16 der Bondzeile 20 mit den Bondflächen 16 der Bondzeile 19 verbinden, so dass das Keramiksubstrat 10 mit der Leiterplatte 11 scharnierartig verbunden ist. Die Bonddrähte 9 bilden nicht nur ein mechanisches Scharnier, sondern dienen gleichzeitig der elektrischen Verbindung zwischen der Leiterbahnstruktur des Keramiksubstrats 10 und der Leiterbahnstruktur der Leiterplatte 11.

Figur 4 zeigt eine perspektivische Prinzipskizze eines Leistungsmoduls 3 mit umgeklapptem zweiten Substrat 2. Der Vorgang des Umklappens des zweiten Substrats 2 über das erste Substrat 1 wird in vier Positionen dargestellt, wobei die Pfeile A, B und C die Umklappbewegung für das zweite Substrat 2 darstellen. Bei diesem Umklappen verbiegen sich die Bonddrähte 9 scharnierartig und aufgrund ihrer Steifheit nach dem Verbiegen definieren sie den Abstand d zwischen dem ersten Substrat 1 und dem zweiten Substrat 2. Vor dem Umklappen sind die Bondflächen 16 in den Randbereichen 17 der beiden Substrate 1 und 2 derart angeordnet, dass mit einem Bondwerkzeug der Bonddraht 9 sicher auf den Bondflächen 16 befestigt werden kann.

Das Umklappen kann mit Hilfe eines Vakuumwerkzeugs automatisch durchgeführt werden. Die Außenflachleiter 28 für eine Signalübertragung sind elektrisch über die Leiterbahnstruktur 34, die Bondflächen 16 und die scharnierartig gebogenen Bonddrähte 9 mit den Signalhalbleiterchips 6 des zweiten Substrats 2 elektrisch verbunden. Die Außenflachleiter 27, die ebenfalls auf dem Keramiksubstrat 10 mit ihren inneren Flachleiterenden 14 fixiert sind, sind über die Leiterbahnstruktur 34 und die Bondverbindungen 13 mit den Leistungshalbleiterchips 4 elektrisch verbunden. Mit der gestrichelten Linie 35 werden in Figur 4 die Umrisse einer Kunststoffgehäusemasse 21 dargestellt, die nach dem Umklappen des zweiten Substrats 2 aufgebracht werden kann.

Figur 5 zeigt eine perspektivische Prinzipskizze eines Leistungsmoduls 3 mit umgeklapptem zweiten Substrat 2. Die Kunststoffgehäusemasse ist in der Darstellungsform der Figur 5 weggelassen, um die relativ flache Anordnung der beiden Substrate 1 und 2 übereinander zu demonstrieren. Somit kann mit dem erfindungsgemäßen Verfahren ein kompaktes Leistungsmodul hergestellt werden, das ohne aufwendige Stützstrukturen und Verbindungsstrukturen zwischen den beiden Substraten 1 und 2 auskommt und dennoch ein Leistungsmodul 3 bildet, das mit intelligenter Steuerungs- und Logiktechnik ausgestattet ist.

Figur 6 zeigt eine perspektivische Prinzipskizze eines Leistungsmoduls 3 einer weiteren Ausführungsform der Erfindung, wobei mit den gestrichelten Linien 35 die Umrisse des Kunststoffgehäuses 18 gezeigt werden. Diese Ausführungsform der Erfindung nach Figur 6 unterscheidet sich von der Ausführungsform nach Figur 1 dadurch, dass sowohl die Außenflachleiter 27 für eine Leistungsübertragung als auch die Außenflachleiter 28 für eine Signalübertragung horizontal aus dem Kunststoffgehäuse 18 herausragen.

## Patentansprüche

1. Leistungsmodul mit einem ersten Substrat (1), das mit Leistungshalbleiterchips (4) bestückt ist und einem zweiten Substrat (2), das mit Signalhalbleiterchips (5) bestückt ist, wobei die Substrate (1, 2) in dem Leistungsmodul (3) parallel übereinander ausgerichtet und ihre Bestückungsseiten (7, 8) zueinander angeordnet sind,
und wobei in benachbarten Randbereichen (17) der Bestückungsseiten (7 bzw. 8) des ersten (1) beziehungsweise des zweiten (2) Substrats in jeweils einer Zeile (19, 20) zueinander ausgerichtete Bondflächen (16) angeordnet sind, und die Zeilen (19, 20) parallel zueinander angeordnet sind, wobei die Bondflächen des ersten Substrats (1) mit den Bondflächen des zweiten Substrats (2) durch parallel zueinander angeordnete, gebogene Bonddrähte (9) einer Dicke von 100 µm bis 300 µm derart miteinander elektrisch verbunden sind, dass durch die Steifheit der Bonddrähte (9) die beiden Substrate (1, 2) in definiertem Abstand voneinander mechanisch fixiert und in eine Kunststoffgehäusemasse (18) einbettbar sind.

2. Leistungsmodul nach Anspruch 1,
**dadurch gekennzeichnet, dass**
das mit Leistungshalbleiterchips (4) bestückte erste Substrat (1) eine Keramikplatte (10) ist.

3. Leistungsmodul nach Anspruch 2,
**dadurch gekennzeichnet, dass**
das mit Leistungshalbleiterchips (4) bestückte erste Substrat (1) eine mehrlagige Keramikplatte (10) ist.

4. Leistungsmodul nach einem der vorhergehenden Ansprüche,
**dadurch gekennzeichnet, dass**
das mit Signalhalbleiterchips (5) bestückte zweite Substrat (2) eine Leiterplatte (11) aus glasfaserverstärktem Kunststoff ist.

5. Leistungsmodul nach Anspruch 4,
**dadurch gekennzeichnet, dass**
das mit Signalhalbleiterchips (5) bestückte zweite Substrat (2) eine mehrlagige Leiterplatte (11) aus glasfaserverstärktem Kunststoff ist.

6. Leistungsmodul nach einem der vorhergehenden Ansprüche,
**dadurch gekennzeichnet, dass**
das mit Signalhalbleiterchips (5) bestückte zweite Substrat (2) Logik-Halbleiterbauteile (12) aufweist.

7. Leistungsmodul nach einem der vorhergehenden Ansprüche,
**dadurch gekennzeichnet, dass**
das mit Signalhalbleiterchips (5) bestückte zweite Substrat (2) Halbleiterchips (5) mit integrierten Steuerschaltungen aufweist.

8. Leistungsmodul nach einem der vorhergehenden Ansprüche,
**dadurch gekennzeichnet, dass**
das mit Signalhalbleiterchips (5) bestückte zweite Substrat (2) Halbleiterchips (5) mit integrierten Treiberschaltungen aufweist.

9. Leistungsmodul nach einem der vorhergehenden Ansprüche,
**dadurch gekennzeichnet, dass**
das mit Signalhalbleiterchips (5) bestückte zweite Substrat (2) Halbleiterchips (5) mit Temperatursensoren aufweist.

10. Leistungsmodul nach einem der vorhergehenden Ansprüche,
**dadurch gekennzeichnet, dass**
das mit Signalhalbleiterchips (5) bestückte zweite Substrat (2) Halbleiterchips (5) mit passiven Komponenten, wie Widerständen, Kondensatoren oder Induktivitäten aufweist.

11. Leistungsmodul nach einem der vorhergehenden Ansprüche,
**dadurch gekennzeichnet, dass**
das mit Leistungshalbleiterchips (4) bestückte erste Substrat (1) Halbleiterchips (4) mit bipolaren Leistungstransistoren mit isoliertem Gate aufweist.

12. Leistungsmodul nach einem der vorhergehenden Ansprüche,
**dadurch gekennzeichnet, dass**
das mit Leistungshalbleiterchips (4) bestückte erste Substrat (1) Halbleiterchips (4) mit Metalloxid-Leistungsfeldeffekttransistoren aufweist.

13. Leistungsmodul nach einem der vorhergehenden Ansprüche,
**dadurch gekennzeichnet, dass**
die Leistungshalbleiterchips (4) auf dem ersten Substrat (1) über Bonddrähte (13) und/oder Leiterbahnen unmittelbar auf dem ersten Substrat (1) untereinander und mit inneren Flachleiterenden (14) von Außenflachleitern (15) verbunden sind.

14. Leistungsmodul nach einem der vorhergehenden Ansprüche,
**dadurch gekennzeichnet, dass**
die Signalhalbleiterchips (5) über Leiterbahnen auf dem zweiten Substrat (2) und die gebogenen Bonddrähte (9) mit den Leistungshalbleiterchips (4) auf dem ersten Substrat (1) und/oder mit Außenflachleitern (15) elektrisch verbunden sind.

15. Leistungsmodul nach einem der vorhergehenden Ansprüche, **dadurch gekennzeichnet**e **dass**
die gebogenen Bonddrähte (9) Aluminium und/oder eine Aluminiumlegierung aufweisen.

16. Verfahren zur Herstellung eines Leistungsmoduls gemäß Anspruch 1, wobei das Verfahren folgende Verfahrensschritte aufweist:
- Bereitstellen eines ersten Substrats (1), das mit Leistungshalbleiterchips (4) bestückt ist und eines zweiten Substrats (2), das mit Signalhalbleiterchips (5) bestückt ist,
- Ausrichten der beiden Substrate (1, 2), so dass ihre Bestückungsseiten (7, 8) nebeneinander angeordnet sind, wobei die Substrate (1, 2) in jeweils einer Zeile angeordnete Bondflächen (16) in nebeneinander liegenden Randbereichen (17) der Bestückungsseiten (7 bzw. 8) aufweisen,
- Verbinden der Substrate (1, 2) mit Bonddrähten (9) an den Bondflächen (16) der jeweiligen Randbereiche (17), wobei die Bonddrähte (9)parallel zueinander angeordnet werden,
- Umklappen des zweiten Substrats (2) um 180°, wobei die Bonddrähte (9) die Funktion eines Scharniers ausüben, so dass die Substrate (1, 2) parallel übereinander ausgerichtet und ihre Bestückungsseiten (7, 8) zueinander angeordnet sind,
- Verpacken des Leistungsmoduls (3) in einem Kunststoffgehäuse (18).

17. Verfahren nach Anspruch 16,
**dadurch gekennzeichnet, dass**
zum Bereitstellen eines ersten Substrats (1) mit Leistungshalbleiterchips (4) eine Keramikplatte (10) mit einer Leiterbahnstruktur beschichtet wird, die in einem Randbereich (17) eine Zeile (19) nebeneinander unter vorgegebenem Rastermaß angeordnetem Bondflächen (16) aufweist, wobei auf dem ersten Substrat (1) die Leistungshalbleiterchips (4) angeordnet werden und untereinander sowie mit der Leiterbahnstruktur über Bonddrähte (13) unter Freilassung der Bondflächenzeile (19) verbunden werden und wobei zusätzlich auf der Keramikplatte (10) innere Flachleiterenden (14) von Außenflachleitern (15) unter Verbinden mit der Leiterbahnstruktur fixiert werden.

18. Verfahren nach Anspruch 16 oder Anspruch 17,
**dadurch gekennzeichnet, dass**
zum Bereitstellen eines zweiten Substrats (2) mit Signalhalbleiterchips (5) eine Leiterplatte (11) mit einer Leiterbahnstruktur versehen wird, die in einem Randbereich eine Zeile (20) nebeneinander angeordnete Bondflächen (16) aufweist deren Anzahl und Rastermaß der Bondflächenzeile (19) des ersten Substrats (1) entspricht, wobei auf dem zweiten Substrat (2) die Signalhalbleiterchips (5) angeordnet werden und untereinander sowie mit der Leiterbahnstruktur über Bonddrähte (13) unter Freilassung der Bondflächenzeile (20) verbunden werden.

19. Verfahren nach einem der Ansprüche 16 bis 18,
**dadurch gekennzeichnet, dass**
zum Ausrichten der beiden Substrate (1, 2) die Bondflächenzeilen (19, 20) der Substrate (1, 2) nebeneinander angeordnet werden, so dass Bonddrähte (9) auf die ausgerichteten und zueinander angepassten Bondflächen (16) der beiden Substrate (1, 2) aufgebracht werden können.

20. Verfahren nach einem der Ansprüche 16 bis 19,
**dadurch gekennzeichnet, dass**
das Verbinden der Substrate (1, 2) durch Aufbringen von Bonddrähten (9) zwischen den Bondflächen (16) mittels Thermokompressions-Sonicbonden von Aluminium- und/oder Aluminiumlegierungs-Bonddrähten (9) mit einem Durchmesser zwischen 100 und 300 Mikrometern erfolgt.

21. Verfahren nach Anspruch 16,
**dadurch gekennzeichnet, dass**
das Verpacken des Leistungsmoduls (3) in einem Kunststoffgehäuse (18) mittels Spritzgusstechnik unter Einbetten der übereinander angeordneten Substrate (1, 2) in eine Kunststoffgehäusemasse (21) erfolgt.

22. Verfahren nach Anspruch 16,
**dadurch gekennzeichnet, dass**
das Verpacken des Leistungsmoduls (3) in einem Kunststoffgehäuse (18) durch Anordnen der beiden Substrate (1, 2) in einem vorgefertigten Kunststoffgehäuse (22) erfolgt und die Hohlräume (23) zwischen den Substraten (1, 2) und dem vorgefertigten Kunststoffgehäuse (22) mit Siliconmasse (24) aufgefüllt werden.

23. Verfahren nach Anspruch 16,
**dadurch gekennzeichnet, dass**
vor dem Verpacken des Leistungsmoduls (3) in einem Kunststoffgehäuse (18) das erste Substrat (1) auf einer Metallplatte (25) vorzugsweise aus Kupfer oder einer Kupferlegierung als Wärmesenke montiert wird, wobei die Metallplatte (25) eine Außenwand des Kunststoffgehäuses (18) bildet.

## Claims

1. Power module having a first substrate (1) populated with power semiconductor chips (4), and having a second substrate (2) populated with signal semiconductor chips (5), the substrates (1, 2) in the power module (3) being oriented parallel one above the other and their placement sides (7, 8) being arranged with respect to one another, bonding areas (16) aligned with one another in a respective row (19, 20) being arranged in adjacent edge regions (17) of the placement sides (7 and 8) of the first (1) and of the second (2) substrate, respectively, and the rows (19, 20) being arranged parallel to one another, the bonding areas of the first substrate (1) being electrically interconnected with the bonding areas of the second substrate (2) by means of bent bonding wires (9) arranged parallel to one another and having a thickness of 100 µm to 300 µm in such a way that, by means of the stiffness of the bonding wires (9), the two substrates (1, 2) are mechanically fixed at a defined distance from one another and can be embedded into a plastic housing composition (18).

2. Power module according to Claim 1,
**characterized in that**
the first substrate (1) populated with power semiconductor chips (4) is a ceramic board (10).

3. Power module according to Claim 2,
**characterized in that**
the first substrate (1) populated with power semiconductor chips (4) is a multilayer ceramic board (10).

4. Power module according to one of the preceding claims,
**characterized in that**
the second substrate (2) populated with signal semiconductor chips (5) is a printed circuit board (11) made of glass-fiber-reinforced plastic.

5. Power module according to Claim 4
**characterized in that**
the second substrate (2) populated with signal semiconductor chips (5) is a multilayer printed circuit board (11) made of glass-fiber-reinforced plastic.

6. Power module according to one of the preceding claims,
**characterized in that**
the second substrate (2) populated with signal semiconductor chips (5) has logic semiconductor components (12).

7. Power module according to one of the preceding claims,
**characterized in that**
the second substrate (2) populated with signal semiconductor chips (5) has semiconductor chips (5) with integrated control circuits.

8. Power module according to one of the preceding claims,
**characterized in that**
the second substrate (2) populated with signal semiconductor chips (5) has semiconductor chips (5) with integrated driver circuits.

9. Power module according to one of the preceding claims,
**characterized in that**
the second substrate (2) populated with signal semiconductor chips (5) has semiconductor chips (5) with temperature sensors.

10. Power module according to one of the preceding claims,
**characterized in that**
the second substrate (2) populated with signal semiconductor chips (5) has semiconductor chips (5) with passive components, such as resistors, capacitors or inductances.

11. Power module according to one of the preceding claims,
**characterized in that**
the first substrate (1) populated with power semiconductor chips (4) has semiconductor chips (4) with insulated gate bipolar power transistors.

12. Power module according to one of the preceding claims,
**characterized in that**
the first substrate (1) populated with power semiconductor chips (4) has semiconductor chips (4) with metal oxide power field effect transistors.

13. Power module according to one of the preceding claims,
**characterized in that**
the power semiconductor chips (4) on the first substrate (1) are connected via bonding wires (13) and/or conductor tracks directly on the first substrate (1) among one another and to inner lead ends (14) of external leads (15).

14. Power module according to one of the preceding claims,
**characterized in that**
the signal semiconductor chips (5) are electrically connected via conductor tracks on the second substrate (2) and the bent bonding wires (9) to the power semiconductor chips (4) on the first substrate (1) and/or to external leads (15).

15. Power module according to one of the preceding claims,
**characterized in that**
the bent bonding wires (9) comprise aluminum and/or an aluminum alloy.

16. Method for producing a power module according to Claim 1, the method having the following method steps:
- provision of a first substrate (1) populated with power semiconductor chips (4), and of a second substrate (2) populated with signal semiconductor chips (5),
- orientation of the two substrates (1, 2) such that their placement sides (7, 8) are arranged next to one another, the substrates (1, 2) having bonding areas (16) arranged in a respective row in edge regions (17) of the placement sides (7 and 8, respectively) that lie next to one another.
- connection of the substrates (1, 2) to bonding wires (9) at the bonding areas (16) of the respective edge regions (17), the bonding wires (9) being arranged parallel to one another,
- folding over of the second substrate (2) through 180°, the bonding wires (9) performing the function of a hinge, so that the substrates (1, 2) are oriented parallel one above the other and their placement sides (7, 8) are arranged with respect to one another,
- packaging of the power module (3) in a plastic housing (18).

17. Method according to Claim 16,
**characterized in that**
in order to provide a first substrate (1) with power semiconductor chips (4), a ceramic board (10) is coated with a conductor track structure having, in an edge region (17), a row (19) of bonding areas (16) arranged next to one another with a predetermined grid dimension, the power semiconductor chips (4) being arranged on the first substrate (1) and being connected among one another and also to the conductor track structure via bonding wires (13) with the bonding area row (19) being left free, and in addition, on the ceramic board (10), inner lead ends (14) of external leads (15) being fixed with connection to the conductor track structure.

18. Method according to Claim 16 or Claim 17,
**characterized in that**
in order to provide a second substrate (2) with signal semiconductor chips (5), a printed circuit board (11) is provided with a conductor track structure having, in an edge region, a row (20) of bonding areas (16) arranged next to one another, the number and grid dimension of which correspond to the bonding area row (19) of the first substrate (1), the signal semiconductor chips (5) being arranged on the second substrate (2) and being connected among one another and also to the conductor track structure via bonding wires (13) with the bonding area row (20) being left free.

19. Method according to one of Claims 16 to 18,
**characterized in that**
in order to orient the two substrates (1, 2), the bonding area rows (19, 20) of the substrates (1, 2) are arranged next to one another, so that it is possible to apply bonding wires (9) to the oriented bonding areas (16) of the two substrates (1, 2) that are adapted to one another.

20. Method according to one of Claims 16 to 19,
**characterized in that**
the substrates (1, 2) are connected by application of bonding wires (9) between the bonding areas (16) by means of thermocompression sonic bonding of aluminum and/or aluminum alloy bonding wires (9) with a diameter of between 100 and 300 micrometers.

21. Method according to Claim 16,
**characterized in that**
the packaging of the power module (3) in a plastic housing (18) is effected by means of injection molding technology with the substrates (1, 2) arranged one above the other being embedded in a plastic housing composition (21).

22. Method according to Claim 16,
**characterized in that**
the packaging of the power module (3) in a plastic housing (18) is effected by arranging the two substrates (1, 2) in a prefabricated plastic housing (22) and the cavities (23) between the substrates (1, 2) and the prefabricated plastic housing (22) are filled with silicone composition (24).

23. Method according to Claim 16,
**characterized in that**
before the power module (3) is packaged in a plastic housing (18), the first substrate (1) is mounted on a metal board (25) preferably made of copper or a copper alloy as heat sink, the metal board (25) forming an outer wall of the plastic housing (18).

## Revendications

1. Module de puissance comprenant un premier substrat (1) qui est équipé de puces en semiconducteur de puissance (4) et un deuxième substrat (2) qui est équipé de puces en semiconducteur de signal (5), les substrats (1, 2) étant orientés parallèlement l'un au-dessus de l'autre dans le module de puissance (3) et leurs côtés équipés (7, 8) étant disposés l'un vers l'autre et des surfaces de liaison (16) orientées les unes vers les autres étant à chaque fois disposées en une ligne (19, 20) dans les zones de bordure voisines (17) des côtés équipés (7 ou 8) du premier (1) ou du deuxième (2) substrat et les lignes (19, 20) étant disposées parallèlement l'une à l'autre, les surfaces de liaison du premier substrat (1) étant reliées électriquement avec les surfaces de liaison du deuxième substrat (2) par des fils de liaison courbés (9) d'une épaisseur de 100 µm à 300 µm disposés parallèlement les uns aux autres de telle sorte que du fait de la rigidité des fils de liaison (9), les deux substrats (1, 2) peuvent être fixés mécaniquement à une distance donnée l'un de l'autre puis incorporés dans une masse de boîtier en matière plastique (18).

2. Module de puissance selon la revendication 1, **caractérisé en ce que** le premier substrat (1) équipé des puces en semiconducteur de puissance (4) est une plaque en céramique (10).

3. Module de puissance selon la revendication 2, **caractérisé en ce que** le premier substrat (1) équipé des puces en semiconducteur de puissance (4) est une plaque en céramique multicouche (10).

4. Module de puissance selon l'une des revendications précédentes, **caractérisé en ce que** le deuxième substrat (2) équipé des puces en semiconducteur de signal (5) est un circuit imprimé (11) en matière plastique renforcée de fibres de verre.

5. Module de puissance selon la revendication 4, **caractérisé en ce que** le deuxième substrat (2) équipé des puces en semiconducteur de signal (5) est un circuit imprimé multicouche (11) en matière plastique renforcée de fibres de verre.

6. Module de puissance selon l'une des revendications précédentes, **caractérisé en ce que** le deuxième substrat (2) équipé des puces en semiconducteur de signal (5) présente des composants semiconducteurs logiques (12).

7. Module de puissance selon l'une des revendications précédentes, **caractérisé en ce que** le deuxième substrat (2) équipé des puces en semiconducteur de signal (5) présente des puces en semiconducteur (5) avec circuits de commande intégrés.

8. Module de puissance selon l'une des revendications précédentes, **caractérisé en ce que** le deuxième substrat (2) équipé des puces en semiconducteur de signal (5) présente des puces en semiconducteur (5) avec circuits d'attaque intégrés.

9. Module de puissance selon l'une des revendications précédentes, **caractérisé en ce que** le deuxième substrat (2) équipé des puces en semiconducteur de signal (5) présente des puces en semiconducteur (5) avec capteurs de température.

10. Module de puissance selon l'une des revendications précédentes, **caractérisé en ce que** le deuxième substrat (2) équipé des puces en semiconducteur de signal (5) présente des puces en semiconducteur (5) avec des composants passifs tels que des résistances, des condensateurs ou des inductances.

11. Module de puissance selon l'une des revendications précédentes, **caractérisé en ce que** le premier substrat (1) équipé des puces en semiconducteur de puissance (4) présente des puces en semiconducteur (4) avec des transistors de puissance bipolaires à gâchette isolée.

12. Module de puissance selon l'une des revendications précédentes, **caractérisé en ce que** le premier substrat (1) équipé des puces en semiconducteur de puissance (4) présente des puces en semiconducteur (4) avec des transistors à effet de champ de puissance à oxyde métallique.

13. Module de puissance selon l'une des revendications précédentes, **caractérisé en ce que** les puces en semiconducteur de puissance (4) sur le premier substrat (1) sont reliées directement entre elles par le biais de fils de liaison (13) et/ou de pistes conductrices sur le premier substrat (1) et avec les extrémités intérieures de conducteurs plats (14) de conducteurs plats externes (15).

14. Module de puissance selon l'une des revendications précédentes, **caractérisé en ce que** les puces en semiconducteur de signal (5) sont reliées électriquement par le biais de pistes conductrices sur le deuxième substrat (2) et les fils de liaison courbés (9) avec les puces en semiconducteur de puissance (4) sur le premier substrat (1) et/ou avec des conducteurs plats externes (15).

15. Module de puissance selon l'une des revendications précédentes, **caractérisé en ce que** les fils de liaison courbés (9) présentent de l'aluminium et/ou un alliage en aluminium.

16. Procédé pour fabriquer un module de puissance selon la revendication 1, le procédé présentant les étapes suivantes :
- mise à disposition d'un premier substrat (1) qui est équipé de puces en semiconducteur de puissance (4) et d'un deuxième substrat (2) qui est équipé de puces en semiconducteur de signal (5),
- orientation des deux substrats (1, 2) de sorte que leurs côtés équipés (7, 8) soient disposés l'un à côté de l'autre, les substrats (1, 2) présentant des surfaces de liaison (16) à chaque fois disposées en une ligne dans les zones de bordure voisines (17) des côtés équipés (7 ou 8),
- liaison des substrats (1, 2) avec les fils de liaison (9) sur les surfaces de liaison (16) des zones de bordure (17) correspondantes, les fils de liaison (9) étant disposés parallèlement les uns aux autres,
- retournement du deuxième substrat (2) de 180°, les fils de liaison (9) exerçant la fonction d'une charnière de sorte que les substrats (1, 2) soient orientés en parallèle l'un au-dessus de l'autre et leurs côtés équipés (7, 8) soient disposés l'un vers l'autre,
- emballage du module de puissance (3) dans un boîtier en matière plastique (18).

17. Procédé selon la revendication 16, **caractérisé en ce que** pour la mise à disposition d'un premier substrat (1) muni de puces en semiconducteur de puissance (4), une plaque en céramique (10) est revêtue d'une structure à pistes conductrices qui présente dans une zone de bordure (17) une ligne (19) de surfaces de liaison (16) disposées les unes à côté des autres selon une cote de quadrillage prédéfinie, les puces en semiconducteur de puissance (4) étant disposées sur le premier substrat (1) et étant reliées entre elles ainsi qu'avec la structure à pistes conductrices par le biais de fils de liaison (13) en laissant libre la ligne de surfaces de liaison (19) et des extrémités intérieures de conducteurs plats (14) de conducteurs plats externes (15) étant en plus fixées sur la plaque en céramique (10) en étant reliées avec la structure à pistes conductrices.

18. Procédé selon la revendication 16 ou la revendication 17, **caractérisé en ce que** pour la mise à disposition d'un deuxième substrat (2) muni de puces en semiconducteur de signal (5), un circuit imprimé (11) est muni d'une structure à pistes conductrices qui présente dans une zone de bordure une ligne (20) de surfaces de liaison (16) disposées les unes à côté des autres dont le nombre et la cote de quadrillage correspondent à ceux de la ligne de surfaces de liaison (19) du premier substrat (1), les puces en semiconducteur de signal (5) étant disposées sur le deuxième substrat (2) et étant reliées entre elles ainsi qu'avec la structure à pistes conductrices par le biais de fils de liaison (13) en laissant libre la ligne de surfaces de liaison (20).

19. Procédé selon l'une des revendications 16 à 18, **caractérisé en ce que** pour l'orientation des deux substrats (1, 2), les lignes de surfaces de liaison (19, 20) des substrats (1, 2) sont disposées l'une à côté de l'autre de sorte que les fils de liaison (9) puissent être déposés sur les surfaces de liaison (16) orientées et adaptées les unes aux autres des deux substrats (1, 2).

20. Procédé selon l'une des revendications 16 à 19, **caractérisé en ce que** la liaison des substrats (1, 2) par la dépose des fils de liaison (9) entre les surfaces de liaison (16) est réalisée au moyen d'une liaison sonique par thermocompression de fils de liaison (9) en aluminium et/ou en alliage d'aluminium ayant un diamètre entre 100 et 300 micromètres.

21. Procédé selon la revendication 16, **caractérisé en ce que** l'emballage du module de puissance (3) dans un boîtier en matière plastique (18) est réalisé par technique de moulage par injection en incorporant les substrats (1, 2) disposés l'un au-dessus de l'autre dans une masse de boîtier en matière plastique (21).

22. Procédé selon la revendication 16, **caractérisé en ce que** l'emballage du module de puissance (3) dans un boîtier en matière plastique (18) est réalisé en disposant les deux substrats (1, 2) dans un boîtier en matière plastique préfabriqué (22) et les espaces creux (23) entre les substrats (1, 2) et le boîtier en matière plastique préfabriqué (22) sont remplis d'une masse de silicone (24).

23. Procédé selon la revendication 16, **caractérisé en ce qu'**avant l'emballage du module de puissance (3) dans un boîtier en matière plastique (18), le premier substrat (1) est monté sur une plaque métallique (25) de préférence en cuivre ou en un alliage de cuivre faisant office de dissipateur thermique, la plaque métallique (25) formant une paroi extérieure du boîtier en matière plastique (18).
